# EUROPEAN PATENT APPLICATION

(11) **EP 4 716 435 A1**
(43) Date of publication of application: **25.03.2026**
(21) Application number: 23937819.3
(22) Date of filing: 19.05.2023
(51) Int. Cl.: H10K 30/88

(54) **PEROVSKITE CELL AND PHOTOVOLTAIC MODULE**

(71) Applicant: Contemporary Amperex Technology Co., Limited, Ningde City, Fujian 352100 (CN)
(72) Inventor: CHEN, Changsong, Ningde Fujian 352100 (CN); MA, Junfu, Ningde Fujian 352100 (CN); XIANG, Ling, Ningde Fujian 352100 (CN); LIN, Zuchao, Ningde Fujian 352100 (CN); ZHOU, Limei, Ningde Fujian 352100 (CN); GUO, Yongsheng, Ningde Fujian 352100 (CN); OUYANG, Chuying, Ningde Fujian 352100 (CN)
(74) Representative: Gong, Jinping
(86) International application number: PCT/CN2023/095251
(87) International publication number: WO 2024/239140

(57) **Abstract**

The present application provides a perovskite cell and a photovoltaic module, and the perovskite cell comprises a first electrode, a second electrode, a light absorbing layer, a hole transport layer and an electron transport layer. The light absorbing layer is located between the first electrode and the second electrode, the hole transport layer is located between the first electrode and the light absorbing layer, and the electron transport layer is located between the second electrode and the light absorbing layer. The perovskite cell further comprises a passivation layer; the passivation layer is located between the hole transport layer and the light absorbing layer, and/or the passivation layer is located between the electron transport layer and the light absorbing layer; and the passivation layer comprises at least two of an organic molecular passivation material, a metal oxide semiconductor material and a metal halide.

## Description

### TECHNICAL FIELD

The present application relates to a perovskite cell and a photovoltaic module.

### BACKGROUND

With the development of modern industry, the problems of global energy shortage and environmental pollution have become increasingly prominent, and solar cells have attracted more and more attention as an ideal renewable energy source. Perovskite cells are solar cells that use perovskite materials as light absorbing layers. The goal of researchers is to further enhance the energy conversion efficiency of perovskite cells. The above statements are intended solely to offer background information relevant to the present application and do not necessarily constitute the prior art.

### SUMMARY OF THE INVENTION

The present application provides a perovskite cell and a photovoltaic module that can improve the energy conversion efficiency of the perovskite cell.

In a first aspect, the present application provides a perovskite cell, comprising a first electrode, a second electrode, a light absorbing layer, a hole transport layer and an electron transport layer; the light absorbing layer is located between the first electrode and the second electrode, the hole transport layer is located between the first electrode and the light absorbing layer, and the electron transport layer is located between the second electrode and the light absorbing layer, wherein the perovskite cell further comprises a passivation layer, the passivation layer is located between the hole transport layer and the light absorbing layer, and/or the passivation layer is located between the electron transport layer and the light absorbing layer; and the passivation layer comprises at least two of an organic molecular passivation material, a metal oxide semiconductor material and a metal halide.

When the passivation layer comprises at least two of an organic molecular passivation material, a metal oxide semiconductor material and a metal halide, the passivation layer can simultaneously have the effects of energy level matching, interface passivation, and optimization of the crystallization quality of perovskite materials, which is conductive to improving the energy conversion efficiency of perovskite cells. In addition, when the passivation layer comprises at least two of an organic molecular passivation material, a metal oxide semiconductor material, and a metal halide, the passivation layer has good stability and can also reduce the erosion of perovskite materials by water and oxygen, thereby improving the stability and service life of the perovskite cell.

In any embodiment, the passivation layer comprises an organic molecular passivation material and a metal oxide semiconductor material and/or a metal halide. Organic molecular passivation materials can act as both interface adhesives and defect passivators, so that the interface contact between the light absorbing layer and the charge transport layer can be enhanced through the organic molecular passivation material. The defect density in the bulk and interface of the perovskite material can also be reduced through the coordination effect of the organic molecular passivation material, thereby improving the film formation quality of the light absorbing layer. The organic molecular passivation material can also be embedded in the bulk of the perovskite material to play an anchoring role to reduce the precipitation of halides (such as PbI₂) from the perovskite material, thereby improving the stability and service life of the perovskite cell. Therefore, organic molecular passivation materials can achieve a better passivation effect. When used in combination with metal oxide semiconductor materials and/or metal halides, they can further reduce non-radiative recombination at defects and further improve the energy conversion efficiency of perovskite cells.

Optionally, based on the total weight of the passivation layer, the content of the organic molecular passivation material is 10-30wt%, and more optionally 15-25wt%.

In any embodiment, the passivation layer comprises an organic molecular passivation material, a metal oxide semiconductor material and a metal halide. When the passivation layer comprises an organic molecular passivation material, a metal oxide semiconductor material and a metal halide at the same time, the passivation layer can better balance the effects of energy level matching, interface passivation, and optimization of the crystallization quality of perovskite materials, which helps to further improve the energy conversion efficiency of perovskite cells; it can also further reduce the erosion of perovskite materials by water and oxygen, which helps to further improve the stability and service life of perovskite cells.

Optionally, based on the total weight of the passivation layer, the content of the organic molecular passivation material is 10-30wt%, and more optionally 15-25wt%. Optionally, based on the total weight of the passivation layer, the content of the metal oxide semiconductor material is 40-60wt%, and more optionally 45-55wt%. Optionally, based on the total weight of the passivation layer, the content of the metal halide is 20-40wt%, and more optionally 25-35wt%.

In any embodiment, the passivation layer comprises an organic molecular passivation material and a metal oxide semiconductor material. Optionally, based on the total weight of the passivation layer, the content of the organic molecular passivation material is 10-30wt%, and more optionally 15-25wt%. Optionally, based on the total weight of the passivation layer, the content of the metal oxide semiconductor material is 70-90wt%, and more optionally 75-85wt%.

In any embodiment, the passivation layer comprises an organic molecular passivation material and a metal halide. Optionally, based on the total weight of the passivation layer, the content of the organic molecular passivation material is 10-30wt%, and more optionally 15-25wt%. Optionally, based on the total weight of the passivation layer, the content of the metal halide is 70-90wt%, and more optionally 75-85wt%.

In any embodiment, the thickness of the passivation layer is less than or equal to 30nm, and optionally 1-22nm. When the thickness of the passivation layer is within the above range, the perovskite cell can have high energy conversion efficiency and stability, and can also have high conductivity, which helps to improve the output performance of the perovskite cell.

In any embodiment, the organic molecule passivation material includes one or more of alkylamines and halogen salts thereof, aromatic amines and halogen salts thereof, aromatic heterocyclic compounds, polymers, and their respective derivatives.

In any embodiment, the aromatic heterocyclic compound includes one or more of nitrogen-containing aromatic heterocyclic rings and their derivatives, and optionally includes one or more of carbazole, pyridine, piperidine, and their respective derivatives. When the aromatic heterocyclic compound is within the above range, the nitrogen atom has lone pair electrons, which can better coordinate with the empty orbitals of the metal ions in the perovskite material, thereby providing a better anchoring effect, and which can be embedded in the shallow position of the light absorbing layer through specific atoms and/or functional groups, thereby further reducing interface defects, in turn reducing non-radiative recombination at the defects and improving the energy conversion efficiency of the perovskite cell.

In any embodiment, the polymer includes one or more of polyaniline, polypyridine, polypiperidine, and their respective derivatives. When the polymer is within the above range, the nitrogen atom on the amino or aromatic heterocyclic ring has lone pair electrons, which can better coordinate with the empty orbitals of the metal ions in the perovskite material, thereby providing a better anchoring effect, and which can be embedded in the shallow position of the light absorbing layer through specific atoms and/or functional groups, thereby further reducing interface defects, in turn reducing non-radiative recombination at the defects and improving the energy conversion efficiency of the perovskite cell.

In any embodiment, the organic molecular passivation material includes one or more of N,N-Diethylaniline, 2-Phenylethylamine Hydroiodide, Dopamine, 9,9-Bis(4-aminophenyl)fluorene, [2-(9H-carbazol-9-yl)ethyl]phosphonic acid, [2-(3,6-dimethoxy-9H-carbazol-9-yl)ethyl]phosphonic acid, [4-(3,6-dimethyl-9H-carbazol-9-yl)butyl]phosphoric acid, 4-pyridinecarboxylic acid, polyaniline, polypyridine, polypiperidine, and their respective derivatives. Optionally, the organic molecular passivation material includes one or more of [2-(9H-carbazol-9-yl)ethyl]phosphonic acid, 2-Phenylethylamine Hydroiodide, and their respective derivatives.

When the organic molecular passivation material is within the above range, it can better match the energy level of the perovskite material, better passivate the interface defects between the light absorbing layer and the charge transport layer, passivate the intrinsic point defects and grain boundary defects of the perovskite material, and better optimize the crystallization quality of the perovskite material, thereby further reducing the non-radiative recombination at the defects and improving the energy conversion efficiency of the perovskite cell.

In any embodiment, the metal oxide semiconductor material includes one or more of an intrinsic metal oxide semiconductor material, an N-type metal oxide semiconductor material, and a P-type metal oxide semiconductor material, and optionally includes one or more of SnO₂, TiO₂, ZnO, NiOₓ, CeOₓ, MoO₃, NiMgLiO, CuGaO₂, CuGrO₂, CuO, Cu₂O, and their respective doping materials, where 1≤x≤2.

In any embodiment, when the passivation layer is located between the hole transport layer and the light absorbing layer, the metal oxide semiconductor material includes one or more of an intrinsic metal oxide semiconductor material and a P-type metal oxide semiconductor material, and optionally includes one or more of NiOₓ, CeOₓ, MoO₃, NiMgLiO, CuGaO₂, CuGrO₂, CuO, Cu₂O, and their respective doping materials, where 1≤x≤2. This allows for better hole transport.

In any embodiment, when the passivation layer is located between the electron transport layer and the light absorbing layer, the metal oxide semiconductor material includes one or more of an intrinsic metal oxide semiconductor material and an N-type metal oxide semiconductor material, and optionally includes one or more of SnO₂, TiO₂, ZnO, and their respective doping materials. This allows for better transport of free electrons.

In any embodiment, the particle size of the metal oxide semiconductor material is 100nm or less, optionally 50nm or less, and more optionally 5-10nm.

In any embodiment, the metal element in the metal halide includes one or more of alkali metal elements, alkaline earth metal elements, and transition metal elements, and optionally includes one or more of K, Cs, Pb, and Cu.

In any embodiment, the halogen element in the metal halide includes one or more of F, Cl, Br, and I.

In any embodiment, the metal halide includes one or more of CsF, KCl, PbBr, CuI, and CuI₂, and optionally includes one or more of KCl and CuI.

In any embodiment, the electron transport material in the electron transport layer includes one or more of imide compounds, quinone compounds, fullerene and its derivatives, a second metal oxide, silicon oxide, strontium titanate, calcium titanate, lithium fluoride, and calcium fluoride. Optionally, the metal element in the second metal oxide includes one or more of Mg, Cd, Zn, In, Pb, W, Sb, Bi, Hg, Ti, Ag, Mn, Fe, V, Sn, Zr, Sr, Ga and Cr.

In any embodiment, the hole transport material in the hole transport layer includes one or more of 2,2',7,7'-tetrakis(N,N-p-methoxyanilino)-9,9'-spirobifluorene, methoxytriphenylamine-fluoroformamidine, poly[bis(4-phenyl)(2,4,6-trimethylphenyl)amine], poly(3,4-ethylenedioxythiophene):polystyrenesulfonic acid, poly(3-hexylthiophene), triphenylamine with triptycene as the core, 3,4-ethylenedioxythiophene-methoxytriphenylamine, N-(4-aniline)carbazol-spirobifluorene, polythiophene, phosphate-based unimolecules, carbazole-based unimolecules, sulfonic acid-based unimolecules, triphenylamine-based unimolecules, aromatic unimolecules, a third metal oxide and cuprous thiocyanate, and the metal element in the third metal oxide includes one or more of Ni, Mo and Cu.

In any embodiment, the perovskite material in the light absorbing layer includes one or more of an inorganic halide perovskite material, an organic halide perovskite material, and an organic-inorganic hybrid halide perovskite material.

In any embodiment, the electrode materials of the first electrode and the second electrode each independently include organic conductive materials, inorganic conductive materials or organic-inorganic hybrid conductive materials, and optionally include one or more of poly(3,4-ethylenedioxythiophene), polythiophene, polyacetylene, fluorine-doped tin oxide, indium tin oxide, antimony-doped tin oxide, aluminum-doped zinc oxide, boron-doped zinc oxide, indium-doped zinc oxide, gold, silver, aluminum, copper, carbon and their derivatives.

A second aspect of the present application provides a photovoltaic module, comprising the perovskite cell of the first aspect of the present application.

The photovoltaic module of the present application comprises the perovskite cell provided by the present application, and thus has at least the same advantages as the perovskite cell.

### DESCRIPTION OF DRAWINGS

To more clearly illustrate the technical solutions of embodiments of the present application, the following provides a brief description of the accompanying drawings used in the embodiments of the present application. It is evident that the accompanying drawings described below are only some embodiments of the present application. For those of ordinary skill in the art, other accompanying drawings can also be obtained based on the drawings without any creative effort.
FIG. 1 is a schematic structural view of perovskite cells provided in some embodiments of the present application.
FIG. 2 is a schematic structural view of perovskite cells provided in other embodiments of the present application.
FIG. 3 is a schematic structural view of perovskite cells provided in still other embodiments of the present application.
FIG. 4 is a schematic structural view of perovskite cells provided in still other embodiments of the present application.
FIG. 5 is a schematic structural view of perovskite cells provided in still other embodiments of the present application.
FIG. 6 is a schematic structural view of perovskite cells provided in still other embodiments of the present application.

The accompanying drawings may not be drawn according to an actual scale. Description of reference numerals: 1. First electrode; 2. Hole transport layer; 3. Light absorbing layer; 4. Electron transport layer; 5. Second electrode; and 6. Passivation layer.

### DETAILED DESCRIPTION

Embodiments of the perovskite cell and photovoltaic module of the present application are specifically disclosed below with reference to detailed description of the accompanying drawings. However, there may be cases where unnecessary detailed descriptions are omitted. For example, there are cases where detailed descriptions of well-known items and repeated descriptions of actually identical structures are omitted. This is to avoid unnecessary redundancy in the following descriptions and to facilitate understanding by those skilled in the art. In addition, the drawings and subsequent descriptions are provided for those skilled in the art to fully understand the present application, and are not intended to limit the subject matter recited in the claims.

The "ranges" disclosed in the present application are defined in the form of lower and upper limits. A given range is defined by selecting a lower limit and an upper limit, and the selected lower and upper limits define the boundaries of the particular range. The range defined in this way may include or may not include end values, and may be arbitrarily combined, that is, any lower limit can be combined with any upper limit to form a range. For example, if the ranges 60-120 and 80-110 are listed for specific parameters, it is understood that the ranges 60-110 and 80-120 are also expected. In addition, if the listed minimum range values are 1 and 2 and if the listed maximum range values are 3, 4, and 5, the following ranges can all be expected: 1-3, 1-4, 1-5, 2-3, 2-4, and 2-5. In the present application, unless otherwise specified, the numerical range "a-b" represents an abbreviated representation of any combination of real numbers between a and b, where a and b are both real numbers. For example, the numerical range "0-5" indicates that all real numbers between "0-5" have been listed herein, and "0-5" is only a shortened representation of these numerical combinations. In addition, when a parameter is expressed as an integer greater than or equal to 2, it is equivalent to disclosing that the parameter is, for example, an integer of 2, 3, 4, 5, 6, 7, 8, 9, 10, 11, 12, and the like.

Unless otherwise specifically stated, all embodiments and optional embodiments of the present application may be combined with each other to form new technical solutions, and such technical solutions should be considered as being included in the disclosure of the present application.

Unless otherwise specifically stated, all technical features and optional technical features of the present application may be combined with each other to form new technical solutions, and such technical solutions should be considered as being included in the disclosure of the present application.

Unless otherwise specifically stated, all steps in the present application may be performed sequentially or randomly, and are preferably performed sequentially. For example, the method includes steps (a) and (b), indicating that the method may include steps (a) and (b) performed sequentially, or may include steps (b) and (a) performed sequentially. For example, the reference to the method may further comprise step (c), meaning that step (c) may be added to the method in any order, for example, the method may comprise steps (a), (b) and (c), or may comprise steps (a), (c) and (b), or may comprise steps (c), (a) and (b), and so on.

Unless otherwise specifically stated, the "including" and "comprising" mentioned in the present application mean open-ended, or may be closed-ended. For example, the terms "including" and "comprising" may indicate that other components not listed may be further included or comprised, or only the listed components may be included or comprised.

Unless otherwise specifically stated, in the present application, the term "or" is inclusive. For example, the phrase "A or B" means "A, B, or both A and B." More specifically, the condition "A or B" is satisfied under any one of the following conditions: A is true (or present) and B is false (or absent); A is false (or absent) and B is true (or present); or both A and B are true (or present).

Unless otherwise particularly stated, in the present application, the terms "first", "second" and the like are used to distinguish different objects, not to describe a particular sequence or primary-secondary relationship.

Unless otherwise specified, the terms used in the present application have well-known meanings as commonly understood by those skilled in the art.

Unless otherwise stated, numerical values of parameters mentioned in the present application may be measured using various testing methods commonly used in the art. For example, the numerical values may be measured according to testing methods given in the present application. Unless otherwise stated, all parameters are tested at 25°C.

Embodiments of the present application further provide a perovskite cell.

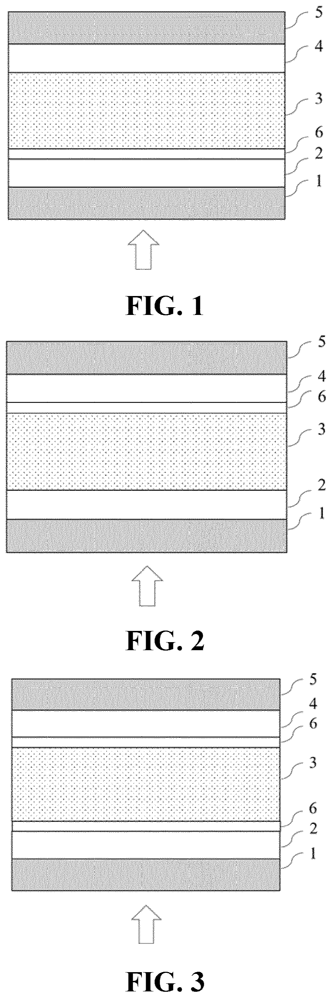

FIGS. 1 to 6 are schematic structural views of perovskite cells provided in some embodiments of the present application.

As shown in FIGS. 1 to 6, the perovskite cell comprises a first electrode 1, a second electrode 5, a light absorbing layer 3, a hole transport layer 2 and an electron transport layer 4. The light absorbing layer 3 is located between the first electrode 1 and the second electrode 5, the hole transport layer 2 is located between the first electrode 1 and the light absorbing layer 3, and the electron transport layer 4 is located between the second electrode 5 and the light absorbing layer 3.

The perovskite cell further comprises a passivation layer 6, the passivation layer 6 is located between the hole transport layer 2 and the light absorbing layer 3, and/or the passivation layer 6 is located between the electron transport layer 4 and the light absorbing layer 3.

The passivation layer 6 comprises at least two of an organic molecular passivation material, a metal oxide semiconductor material and a metal halide.

The working principle of perovskite cells is generally as follows: under illumination conditions, the light absorbing layer absorbs photon energy and generates electron-hole pairs in its valence band, and the electrons are excited to the conduction band and leave holes in the valence band. The conduction band energy level of the light absorbing layer is usually higher than the conduction band energy level of the electron transport layer, so that electrons can be transferred from the conduction band position of the light absorbing layer to the conduction band position of the electron transport layer, and then transferred to the conductive electrode; the valence band energy level of the light absorbing layer is usually lower than the valence band energy level of the hole transport layer, so holes can be transferred to the conductive electrode through the hole transport layer. When the external circuit is connected, a complete loop is formed and photocurrent is generated.

The light absorbing layer comprises a perovskite material. The perovskite material is generally a halide perovskite material (such as an inorganic halide perovskite material, an organic halide perovskite material, and an organic-inorganic hybrid halide perovskite material), and has attracted extensive attention due to its advantages, such as large carrier diffusion length, easily regulatable band gap, high defect tolerance, and low manufacturing costs.

However, the crystallization quality of perovskite materials is poor, which is mainly manifested in small grain size, disordered grain stacking, and multiple grain boundary interfaces. As a result, perovskite materials have more intrinsic point defects (such as vacancy defects, interstitial defects, and antisite defects) and grain boundary defects. In addition, there are many surface defects in the light absorbing layer, mainly manifested in many holes and cracks. Defects will capture the surrounding free electrons and holes. These captured electrons and holes are prone to recombine at the defect center (also known as non-radiative recombination), which will increase the energy loss of perovskite cells and reduce the performance of perovskite cells. Also, compared with the non-radiative recombination at intrinsic point defects or grain boundaries, the non-radiative recombination at the interface between the light absorbing layer and the charge transport layer (such as hole transport layer or electron transport layer) is usually dominant.

Therefore, the poor crystallization quality of perovskite materials and the many interface defects between the light absorbing layer and the charge transport layer are key factors that affect the performance improvement of perovskite cells. Interface passivation is an effective strategy to obtain high-performance perovskite cells.

The passivation layer provided in the embodiments of the present application comprises at least two of an organic molecular passivation material, a metal oxide semiconductor material and a metal halide.

Organic molecular passivation materials, metal oxide semiconductor materials and metal halides can easily provide energy level structures that match perovskite materials.

Organic molecular passivation materials can act as both interface adhesives and defect passivators, so that the interface contact between the light absorbing layer and the charge transport layer can be enhanced through the organic molecular passivation material. The defect density in the bulk and interface of the perovskite material can also be reduced through the coordination effect of the organic molecular passivation material, thereby improving the film formation quality of the light absorbing layer. The organic molecular passivation material can also be embedded in the bulk of the perovskite material to play an anchoring role to reduce the precipitation of halides (such as PbI₂) from the perovskite material, thereby improving the stability and service life of the perovskite cell.

Therefore, organic molecular passivation materials can passivate the interface defects between the light absorbing layer and the charge transport layer, and can also passivate the intrinsic point defects (including vacancy defects, interstitial defects and antisite defects) and grain boundary defects of the perovskite material, thereby improving the interface performance between the light absorbing layer and the charge transport layer, optimizing the crystallization quality of the perovskite material, and in turn reducing non-radiative recombination at the defects and improving the energy conversion efficiency of the perovskite cell. In addition, organic molecular passivation materials can also improve the film formation quality of the passivation layer to effectively block water and oxygen and reducing the corrosion of perovskite materials by water and oxygen, thereby improving the stability and service life of perovskite cells.

Metal oxide semiconductor materials have high stability. In addition, they have better energy level matching with perovskite materials, which can better promote carrier transport and reduce ion migration. Also, metal oxide semiconductor materials can effectively block water and oxygen, reducing the erosion of perovskite materials by water and oxygen, thereby improving the stability and service life of perovskite cells.

Metal halides have high stability and can also play the role of passivating the halogen defects of perovskite materials, and can also optimize the crystallization quality of perovskite materials.

Therefore, when the passivation layer comprises at least two of an organic molecular passivation material, a metal oxide semiconductor material and a metal halide, the passivation layer can simultaneously have the effects of energy level matching, interface passivation, and optimization of the crystallization quality of perovskite materials, which is conductive to improving the energy conversion efficiency of perovskite cells. In addition, when the passivation layer comprises at least two of an organic molecular passivation material, a metal oxide semiconductor material, and a metal halide, the passivation layer has good stability and can also reduce the erosion of perovskite materials by water and oxygen, thereby improving the stability and service life of the perovskite cell.

In some embodiments, the organic molecule passivation material may include one or more of alkylamines and halogen salts thereof, aromatic amines and halogen salts thereof, aromatic heterocyclic compounds, polymers, and their respective derivatives.

In some embodiments, optionally, the aromatic heterocyclic compound may include one or more of nitrogen-containing aromatic heterocyclic rings and their derivatives, and more optionally includes one or more of carbazole, pyridine, piperidine, and their respective derivatives. When the aromatic heterocyclic compound is within the above range, the nitrogen atom has lone pair electrons, which can better coordinate with the empty orbitals of the metal ions in the perovskite material, thereby providing a better anchoring effect, and which can be embedded in the shallow position of the light absorbing layer through specific atoms and/or functional groups, thereby further reducing interface defects, in turn reducing non-radiative recombination at the defects and improving the energy conversion efficiency of the perovskite cell.

In some embodiments, optionally, the polymer may include one or more of polyaniline, polypyridine, polypiperidine, and their respective derivatives. When the polymer is within the above range, the nitrogen atom on the amino or aromatic heterocyclic ring has lone pair electrons, which can better coordinate with the empty orbitals of the metal ions in the perovskite material, thereby providing a better anchoring effect, and which can be embedded in the shallow position of the light absorbing layer through specific atoms and/or functional groups, thereby further reducing interface defects, in turn reducing non-radiative recombination at the defects and improving the energy conversion efficiency of the perovskite cell.

In some embodiments, the organic molecular passivation material may include one or more of N,N-Diethylaniline (DEA), 2-Phenylethylamine Hydroiodide (PEAI), Dopamine, 9,9-Bis(4-aminophenyl)fluorene (FDA), [2-(9H-carbazol-9-yl)ethyl]phosphonic acid (2PACz), [2-(3,6-dimethoxy-9H-carbazol-9-yl)ethyl]phosphonic acid, [4-(3,6-dimethyl-9H-carbazol-9-yl)butyl]phosphoric acid, 4-pyridinecarboxylic acid, polyaniline, polypyridine, polypiperidine, and their respective derivatives.

When the organic molecular passivation material is within the above range, it can better match the energy level of the perovskite material, better passivate the interface defects between the light absorbing layer and the charge transport layer, passivate the intrinsic point defects and grain boundary defects of the perovskite material, and better optimize the crystallization quality of the perovskite material, thereby further reducing the non-radiative recombination at the defects and improving the energy conversion efficiency of the perovskite cell.

The derivatives of the above-mentioned organic molecular passivation materials usually refer to the products derived from the substitution of hydrogen atoms or atomic groups in the organic molecular passivation materials by other atoms or atomic groups.

In some embodiments, the organic molecular passivation material may include one or more of [2-(9H-carbazol-9-yl)ethyl]phosphonic acid (2PACz), 2-Phenylethylamine Hydroiodide (PEAI), and their respective derivatives.

In some embodiments, the metal oxide semiconductor material may include one or more of an intrinsic metal oxide semiconductor material, an N-type metal oxide semiconductor material, and a P-type metal oxide semiconductor material. Optionally, the metal oxide semiconductor material may include one or more of SnO₂, TiO₂, ZnO, NiOₓ(1≤x≤2), CeOₓ(1≤x≤2), MoO₃, NiMgLiO, CuGaO₂, CuGrO₂, CuO, Cu₂O, and their respective doping materials.

In some embodiments, when the passivation layer 6 is located between the hole transport layer 2 and the light absorbing layer 3, the metal oxide semiconductor material may include one or more of an intrinsic metal oxide semiconductor material and a P-type metal oxide semiconductor material, which can better transport holes. Optionally, the metal oxide semiconductor material may include one or more of NiOₓ (1≤x≤2), CeOₓ (1≤x≤2), MoO₃, NiMgLiO, CuGaO₂, CuGrO₂, CuO, Cu₂O, and their respective doping materials.

In some embodiments, when the passivation layer 6 is located between the electron transport layer 4 and the light absorbing layer 3, the metal oxide semiconductor material may include one or more of an intrinsic metal oxide semiconductor material and an N-type metal oxide semiconductor material, which can better transport electrons. Optionally, the metal oxide semiconductor material may include one or more of SnO₂, TiO₂, ZnO, and their respective doping materials.

When the metal oxide semiconductor material is within the above range, it can better match the energy level of the perovskite material, and can also better promote carrier transport and reduce the erosion of perovskite materials by water and oxygen, thereby helping to improve the energy conversion efficiency and/or stability of the perovskite cell.

The doping material of the metal oxides may independently include one or more of an alkali metal element, an alkali earth metal element, a transition metal element, a poor metal element, a metalloid element, a halogen element, a nonmetallic element, an ionic liquid, carboxylic acid, phosphoric acid, a carbon derivative, a self-assembled monomolecule, and a polymer. Optionally, the weight content of the doping material in the metal oxide is ≤30%.

In some embodiments, the particle size of the metal oxide semiconductor material may be 100nm or less, optionally 50nm or less, and more optionally 5-10nm.

In some embodiments, the metal element in the metal halide may include one or more of alkali metal elements, alkaline earth metal elements, and transition metal elements, and optionally includes one or more of K, Cs, Pb, and Cu.

In some embodiments, the halogen element in the metal halide may include one or more of F, Cl, Br, and I.

In some embodiments, the metal halide may include one or more of CsF, KCl, PbBr, CuI and CuI₂. When metal halides are within the above range, they can better match the energy levels of perovskite materials.

In some embodiments, the metal halide may include one or more of CsF, KCl and PbBr, and optionally include one or more of KCl and PbBr. When the metal halide is within the above range, the size of the halogen anion is small, which can better reduce the lattice distortion of the perovskite crystal and is also conductive to releasing stress, thereby better optimizing the crystallization quality of the perovskite material.

In some embodiments, the metal halide may include one or more of CuI and CuI₂. When the metal halide is within the above range, carrier transport can be better promoted.

In some embodiments, the passivation layer may comprise an organic molecular passivation material and a metal oxide semiconductor material and/or a metal halide.

Organic molecular passivation materials can act as both interface adhesives and defect passivators, so that the interface contact between the light absorbing layer and the charge transport layer can be enhanced through the organic molecular passivation material. The defect density in the bulk and interface of the perovskite material can also be reduced through the coordination effect of the organic molecular passivation material, thereby improving the film formation quality of the light absorbing layer. The organic molecular passivation material can also be embedded in the bulk of the perovskite material to play an anchoring role to reduce the precipitation of halides (such as PbI₂) from the perovskite material, thereby improving the stability and service life of the perovskite cell. Therefore, organic molecular passivation materials can achieve a better passivation effect. When used in combination with metal oxide semiconductor materials and/or metal halides, they can further reduce non-radiative recombination at defects and further improve the energy conversion efficiency of perovskite cells.

Optionally, based on the total weight of the passivation layer, the content of the organic molecular passivation material is 10-30wt%, and optionally 15-25wt%. The stability of the organic molecular passivation material itself is slightly poor, so when its content is within the above range, it is also conductive to improving the stability and service life of the perovskite cell.

In some embodiments, the passivation layer 6 may comprise an organic molecular passivation material, a metal oxide semiconductor material and a metal halide. When the passivation layer comprises an organic molecular passivation material, a metal oxide semiconductor material and a metal halide at the same time, the passivation layer can better balance the effects of energy level matching, interface passivation, and optimization of the crystallization quality of perovskite materials, which helps to further improve the energy conversion efficiency of perovskite cells; it can also further reduce the erosion of perovskite materials by water and oxygen, which helps to further improve the stability and service life of perovskite cells.

Optionally, based on the total weight of the passivation layer, the content of the organic molecular passivation material is 10-30wt%, and more optionally 15-25wt%. Optionally, based on the total weight of the passivation layer, the content of the metal oxide semiconductor material is 40-60wt%, and more optionally 45-55wt%. Optionally, based on the total weight of the passivation layer, the content of the metal halide is 20-40wt%, and more optionally 25-35wt%.

When the content of organic molecular passivation materials, metal oxide semiconductor materials and metal halides is within the above ranges, the advantages of each component can be better utilized, which is conductive to further improving the energy conversion efficiency, stability and service life of perovskite cells.

In some embodiments, the passivation layer 6 may comprise an organic molecular passivation material and a metal oxide semiconductor material. Optionally, based on the total weight of the passivation layer, the content of the organic molecular passivation material is 10-30wt%, and more optionally 15-25wt%. Optionally, based on the total weight of the passivation layer, the content of the metal oxide semiconductor material is 70-90wt%, and more optionally 75-85wt%.

In some embodiments, the passivation layer 6 may comprise an organic molecular passivation material and a metal halide. Optionally, based on the total weight of the passivation layer, the content of the organic molecular passivation material is 10-30wt%, and more optionally 15-25wt%. Optionally, based on the total weight of the passivation layer, the content of the metal halide is 70-90wt%, and more optionally 75-85wt%.

In some embodiments, the thickness of the passivation layer 6 may be less than or equal to 30nm, and optionally 1-22 nm, 1-17 nm, 2-22 nm, 2-17 nm, 4-22 nm, 4-17 nm. When the thickness of the passivation layer is within the above range, the perovskite cell can have high energy conversion efficiency and stability, and can also have high conductivity, which helps to improve the output performance of the perovskite cell.

In some examples, the light absorbing layer 3 may comprise a perovskite material. As an intrinsic semiconductor material, the perovskite material can transport both electrons and holes.

Types of the perovskite material are not specifically limited, and may be selected based on actual requirements. In some embodiments, the perovskite material in the light absorbing layer may include one or more of an inorganic halide perovskite material, an organic halide perovskite material, and an organic-inorganic hybrid halide perovskite material.

The perovskite material may have a molecular formula of ABX₃, where A represents an inorganic cation, an organic cation, or an organic-inorganic hybrid cation, B represents an inorganic cation, an organic cation, or an organic-inorganic hybrid cation, and X represents an inorganic anion, an organic anion, and an organic-inorganic hybrid anion.

As an example, A includes one or more of CH₃NH₃⁺(MA⁺), CH(NH₂)₂⁺(FA⁺), Li⁺, Na⁺, K⁺, Rb⁺, and Cs⁺. Optionally, A includes one or more of CH₃NH₃⁺, CH(NH₂)₂⁺, and Cs⁺.

As an example, B includes one or more of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺. Optionally, B includes one or both of Pb²⁺ and Sn²⁺.

As an example, X includes one or more of F⁻, Cl⁻, Br⁻, and I⁻. Optionally, X includes one or more of Cl⁻, Br⁻, and I⁻.

The perovskite material may have a molecular formula of A'₂CDX'₆, where A' represents an inorganic cation, an organic cation, or an organic-inorganic hybrid cation, C represents a monovalent metal cation, D represents a trivalent metal cation, and X' represents an inorganic anion, an organic anion, or an organic-inorganic hybrid anion.

As an example, A' includes one or more of CH₃NH₃⁺(MA⁺), CH(NH₂)₂⁺(FA⁺), Li⁺, Na⁺, K⁺, Rb⁺, and Cs⁺. Optionally, A' includes one or more of CH₃NH₃⁺, CH(NH₂)₂⁺, and Cs⁺.

As an example, C includes at least one of Li⁺, Na⁺, K⁺, Rb⁺, Cs⁺, and Ag⁺.

As an example, D includes at least one of In³⁺ and Bi³⁺.

As an example, X' includes one or more of F⁻, Cl⁻, Br⁻, and I⁻. Optionally, X' includes one or more of Cl⁻, Br⁻, and I⁻.

In some embodiments, the perovskite material may include, but is not limited to, one or more of CH₃NH₃PbI₃ (MAPbI₃), CH(NH₂)₂PbI₃ (FAPbI₃), CsPbI₃, CsPbI₂Br, CsPbIBr₂, Cs₂NaInCl₆, Cs₂KBiCl₆, and Cs₂AgInCl₆.

The thickness of the light absorbing layer 3 is not specifically limited, and may be selected based on actual requirements. For example, in some embodiments, the thickness of the light absorbing layer 3 may be 50-2000nm.

The electron transport layer 4 comprises an electron transport material. Types of the electron transport material are not specifically limited, and may be selected based on actual requirements. For example, the electron transport material may include an organic electron transport material, an inorganic electron transport material, or an organic-inorganic hybrid electron transport material.

In some embodiments, the electron transport material may include one or more of imide compounds, quinone compounds, fullerene and their derivatives, a second metal oxide, silicon oxide, strontium titanate (SrTiO₃), calcium titanate (CaTiO₃), lithium fluoride (LiF), and calcium fluoride (CaF₂). Optionally, the metal element in the second metal oxide may include one or more of Mg, Cd, Zn, In, Pb, W, Sb, Bi, Hg, Ti, Ag, Mn, Fe, V, Sn, Zr, Sr, Ga and Cr.

Optionally, the electron transport material may include one or more of SnO₂, TiO₂, methyl [6,6]-phenyl C₆₁-butyrate (PC₆₁BM), methyl [6,6]-phenyl C₇₁-butyrate (PC₇₁BM), fullerene C60, and fullerene C70. When the electron transport material is within the above range, its conduction band minimum energy level can better match with that of the light absorbing layer, which is conducive to promoting electron transport.

The thickness of the electron transport layer 4 is not specifically limited, and may be selected based on actual requirements. For example, in some embodiments, the thickness of the electron transport layer 4 may be 1-300nm.

The hole transport layer 2 comprises a hole transport material. Types of the hole transport material are not specifically limited, and may be selected based on actual requirements.

In some embodiments, the hole transport material may include one or more of 2,2',7,7'-tetrakis(N,N-p-methoxyanilino)-9,9'-spirobifluorene (Spiro-OMeTAD), methoxytriphenylamine-fluoroformamidine (OMeTPA-FA), poly[bis(4-phenyl)(2,4,6-trimethylphenyl)amine] (PTAA), poly(3,4-ethylenedioxythiophene):polystyrenesulfonic acid (PEDOT:PSS), poly(3-hexylthiophene) (P3HT), triphenylamine with triptycene as the core (H101), 3,4-ethylenedioxythiophene-methoxytriphenylamine (EDOT-OMeTPA), N-(4-aniline)carbazol-spirobifluorene (CzPAF-SBF), polythiophene, phosphate-based unimolecules, carbazole-based unimolecules, sulfonic acid-based unimolecules, triphenylamine-based unimolecules, aromatic unimolecules, a third metal oxide and cuprous thiocyanate (CuSCN). Optionally, the metal element in the third metal oxide may include one or more of Ni, Mo and Cu.

The thickness of the hole transport layer 2 is not specifically limited, and may be selected based on actual requirements. For example, in some embodiments, the thickness of the hole transport layer 2 may be 5-1000nm.

In some embodiments, when the passivation layer 6 is located between the hole transport layer 2 and the light absorbing layer 3, the valence band maximum (VBM) energy level of the light absorbing layer 3 < the valence band maximum (VBM) energy level of the passivation layer 6 < the valence band maximum (VBM) energy level of the hole transport layer 2. This promotes better hole transport.

In some embodiments, when the passivation layer 6 is located between the electron transport layer 4 and the light absorbing layer 3, the conduction band minimum (CBM) energy level of the electron transport layer 4< the conduction band minimum (CBM) energy level of the passivation layer 6 < the conduction band minimum (CBM) energy level of the light absorbing layer 3. This promotes better electron transport.

The energy band distribution of each film layer may be measured by an X-ray photoelectron spectrometer (XPS) and an ultraviolet photoelectron spectrometer (UPS).

In some embodiments, the electrode materials of the first electrode 1 and the second electrode 5 may each independently include organic conductive materials, inorganic conductive materials or organic-inorganic hybrid conductive materials, respectively. For example, the electrode materials of the first electrode 1 and the second electrode 5 may each independently include one or more of a conductive polymer, a metal, a transparent metal conductive oxide, carbon and their derivatives. As an example, the electrode materials of the first electrode 1 and the second electrode 5 each independently include one or more of poly(3,4-ethylenedioxythiophene) (PEDOT), polythiophene, polyacetylene, fluorine-doped tin oxide (FTO), indium tin oxide (ITO), antimony-doped tin oxide (ATO), aluminum-doped zinc oxide (AZO), boron-doped zinc oxide (BZO), indium-doped zinc oxide (IZO), gold, silver, aluminum, copper, carbon and their derivatives.

In some embodiments, the electrode material of one of the first electrode 1 and the second electrode 5 may include a transparent metal conductive oxide, optionally one or more of fluorine-doped tin oxide (FTO), indium tin oxide (ITO), antimony-doped tin oxide (ATO), aluminum-doped zinc oxide (AZO), boron-doped zinc oxide (BZO), and indium-doped zinc oxide (IZO).

In some embodiments, the perovskite cell further comprises a substrate, such as a glass substrate, and a transparent metal conductive oxide may be disposed on the surface of the substrate.

In some embodiments, the electrode material of one of the first electrode 1 and the second electrode 5 may include one or more of metal, carbon and their derivatives, and optionally one or more of gold, silver, aluminum, copper, carbon and their derivatives.

The thickness of the first electrode 1 is not specifically limited, and may be selected based on actual requirements. For example, in some embodiments, the thickness of the first electrode 1 may be 10nm-500nm.

The thickness of the second electrode 5 is not specifically limited, and may be selected based on actual requirements. For example, in some embodiments, the thickness of the second electrode 5 may be 10nm-500nm.

The perovskite cell provided in the embodiments of the present application may be a conventional cell or an inverted cell.

In some embodiments, as shown in FIG. 1, the first electrode 1 is the light incident side, and the perovskite cell (inverted cell) comprises the first electrode 1, the hole transport layer 2, the passivation layer 6, the light absorbing layer 3, the electron transport layer 4 and the second electrode 5 in sequence. In some embodiments, as shown in FIG. 2, the first electrode 1 is the light incident side, and the perovskite cell (inverted cell) comprises the first electrode 1, the hole transport layer 2, the light absorbing layer 3, the passivation layer 6, the electron transport layer 4 and the second electrode 5 in sequence. In some embodiments, as shown in FIG. 1, the first electrode 1 is the light incident side, and the perovskite cell (inverted cell) comprises the first electrode 1, the hole transport layer 2, the passivation layer 6, the light absorbing layer 3, the passivation layer 6, the electron transport layer 4 and the second electrode 5 in sequence.

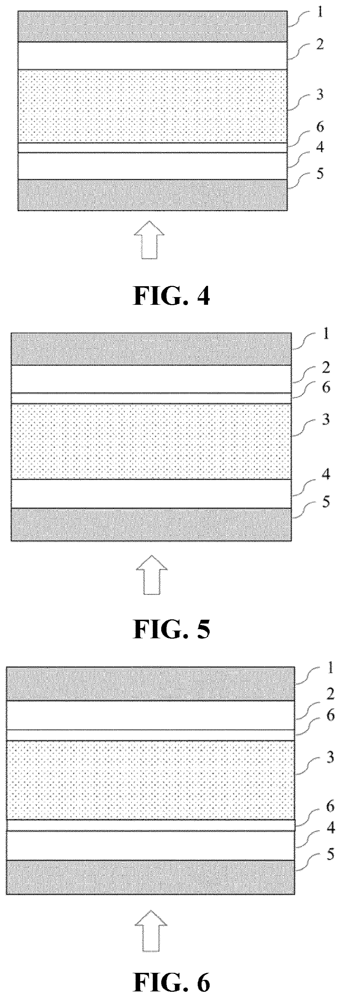

In some embodiments, as shown in FIG. 4, the second electrode 5 is the light incident side, and the perovskite cell (conventional cell) comprises the second electrode 5, the electron transport layer 4, the passivation layer 6, the light absorbing layer 3, the hole transport layer 2 and the first electrode 1 in sequence. In some embodiments, as shown in FIG. 5, the second electrode 5 is the light incident side, and the perovskite cell (conventional cell) comprises the second electrode 5, the electron transport layer 4, the light absorbing layer 3, the passivation layer 6, the hole transport layer 2 and the first electrode 1 in sequence. In some embodiments, as shown in FIG. 6, the second electrode 5 is the light incident side, and the perovskite cell (conventional cell) comprises the second electrode 5, the electron transport layer 4, the passivation layer 6, the light absorbing layer 3, the passivation layer 6, the hole transport layer 2 and the first electrode 1 in sequence.

Optionally, the passivation layer 6 is located between the charge transport layer close to the light incident side and the light absorbing layer. For a conventional cell, the charge transport layer is an electron transport layer, and for an inverted cell, the charge transport layer is a hole transport layer. In this case, the light absorbing layer is formed after the passivation layer, so that the passivation layer can better promote the crystallization of the perovskite material, thereby enabling the perovskite cell to have higher energy conversion efficiency.

In some embodiments, the first electrode 1 is the light incident side, and the perovskite cell (inverted cell) comprises the first electrode 1, the hole transport layer 2, the passivation layer 6, the light absorbing layer 3, the electron transport layer 4 and the second electrode 5 in sequence; the passivation layer 6 comprises an organic molecular passivation material and a metal oxide semiconductor material and/or a metal halide; based on the total weight of the passivation layer, the content of the organic molecular passivation material is 10-30wt%, and optionally 15-25wt%; the metal oxide semiconductor material includes one or more of an intrinsic metal oxide semiconductor material and a P-type metal oxide semiconductor material, and optionally includes one or more of NiOₓ (1≤x≤2), CeOₓ (1≤x≤2), MoO₃, NiMgLiO, CuGaO₂, CuGrO₂, CuO, Cu₂O, and their respective doping materials.

In some embodiments, the second electrode 5 is the light incident side, and the perovskite cell (conventional cell) comprises the second electrode 5, the electron transport layer 4, the passivation layer 6, the light absorbing layer 3, the passivation layer 6, the hole transport layer 2 and the first electrode 1 in sequence; the passivation layer 6 comprises an organic molecular passivation material and a metal oxide semiconductor material and/or a metal halide; based on the total weight of the passivation layer, the content of the organic molecular passivation material is 10-30wt%, and optionally 15-25wt%; the metal oxide semiconductor material includes one or more of an intrinsic metal oxide semiconductor material and an N-type metal oxide semiconductor material, and optionally includes one or more of SnO₂, TiO₂, ZnO, and their respective doping materials.

The perovskite cell provided in the embodiments of the present application is not limited to the above structure, and may further include other functional layers.

The perovskite cell may be prepared in accordance with a method known in the art.

As shown in FIGS. 1 to 3, an exemplary preparation method comprises the steps of providing the first electrode 1, forming the hole transport layer 2 on the first electrode 1, forming the light absorbing layer 3 on the hole transport layer 2, forming the electron transport layer 4 on the light absorbing layer 3, forming the second electrode on the electron transport layer 4, forming the light absorbing layer 3 after forming the passivation layer 6 on the hole transport layer 2, and/or forming the electron transport layer 4 after forming the passivation layer 6 on the light absorbing layer 3.

As shown in FIGS. 4 to 6, another exemplary preparation method comprises: providing the second electrode 5, forming the electron transport layer 4 on the second electrode 5, forming the light absorbing layer 3 on the electron transport layer 4, forming the hole transport layer 2 on the light absorbing layer 3, forming the first electrode 1 on the hole transport layer 2, forming the hole transport layer 2 after forming the passivation layer 6 on the light absorbing layer 3 , and/or forming the light-absorbing layer 3 after forming the passivation layer 6 on the electron transport layer 4.

The film forming method of the above-mentioned film layers is not particularly limited, and the film forming methods known in the art can be adopted, for example, chemical bath deposition, chemical vapor deposition, electrochemical deposition, physical epitaxis, thermal evaporation, atomic layer deposition, magnetron sputtering, precursor solution spin coating, precursor solution slit coating, precursor solution blade coating, mechanical pressing, sol-gel and pulsed laser deposition, and optionally thermal evaporation and precursor solution spin coating.

The perovskite cell provided in the embodiments of the present application may be used alone as a single-junction perovskite cell, or may be combined with a perovskite type or other types of solar cells to form a stacked cell, such as a perovskite-perovskite stacked cell or a perovskite-crystalline silicon stacked cell.

The embodiments of the present application further provides a photovoltaic module, the photovoltaic module comprises the perovskite cell provided in the embodiments of the present application, and the perovskite cell may be used as a power source for the photovoltaic module after processes such as series connection, parallel connection, and encapsulation.

In some embodiments, the photovoltaic module comprises the single-junction perovskite cell, perovskite-perovskite stacked cell, or perovskite-crystalline silicon stacked cell provided in the embodiments of the present application.

### Examples

The following Examples more specifically describe the contents disclosed in the present application. These Examples are intended for illustrative purposes only, because various modifications and changes made within the scope of the contents disclosed in the present application will be apparent to those skilled in the art. Unless otherwise stated, all parts, percentages, and ratios reported in the following Examples are based on weight, all reagents used in the Examples are either commercially available or synthesized according to conventional methods, and may be directly used without further processing, and all the instruments used in the Examples are commercially available.

### Example 1-1

### Preparation of FTO electrode

A glass substrate sized 2.0 cm×2.0 cm and covered with FTO was taken, and its surface was successively washed twice with acetone and isopropanol, respectively. Then, it was immersed in deionized water for ultrasonic treatment for 10 min, then dried in an air dry oven, and kept in a glove box (N₂ atmosphere).

### Preparation of electron transport layer

A 3wt% SnO₂ nano-colloid aqueous solution was spin-coated on an FTO layer at a speed of 4000-6500 rpm, and then heated at 150°C on a thermostatic heating stage for 15min to obtain an electron transport layer with a thickness of 50 nm.

### Preparation of passivation layer

A mixture of 2wt% TiO₂ nanocolloid-isopropanol solution, 0.2 mg/mL 2PACz-isopropanol solution, and 1 mg/mL KCl-isopropanol solution was spin-coated on the electron transport layer at a speed of 5000-6000 rpm, and then heated at 100°C on a thermostatic heating stage for 10min to obtain a passivation layer with a thickness of 17 nm. The weight contents of the components in the passivation layer are shown in Table 1.

### Preparation of light absorbing layer

A solution of 1.5mol/L FAPbI₃ in DMF was spin-coated on the passivation layer at a speed of 3000-4500 rpm, then heated on a thermostatic heating stage at 100°C for 30min, and cooled to room temperature to obtain the light absorbing layer with a thickness of 500 nm.

### Preparation of hole transport layer

A solution of Spiro-OMeTAD (73 mg/mL) in chlorobenzene was spin-coated on the light absorbing layer at a speed of 3000-4000 rpm to obtain a hole transport layer with a thickness of 150 nm.

### Preparation of Ag electrode

The above sample was put into a vacuum coater, and an Ag electrode was evaporated onto the surface of the hole transport layer under the vacuum condition of 5×10⁻⁴ Pa, with an evaporation rate of 0.1 Å/s and a thickness of 80 nm.

The perovskite cell finally prepared in Example 1-1 has a structure of FTO/SnO₂/TiO₂+2PACz+KCl/FAPbI₃/Spiro-OMeTAD/Ag.

### Examples 1-2 to 1-6

Except for the different weight contents of the components in the passivation layer, the preparation of the perovskite cell is the same as that of Example 1-1. The specific parameters are shown in Table 1.

### Examples 1-7 to 1-11

Except for the thickness of the passivation layer, the preparation of the perovskite cell is the same as that of Example 1-1. The specific parameters are shown in Table 1.

### Example 1-12

Except for the difference in the preparation of the passivation layer, the preparation of the perovskite cell is the same as that of Example 1-1.

A mixture of 2wt% TiO₂ nanocolloid-isopropanol solution and 0.2 mg/mL 2PACz-isopropanol solution was spin-coated on the electron transport layer at a speed of 5000-6000 rpm, and then heated at 150°C on a thermostatic heating stage for 30min to obtain a passivation layer with a thickness of 15 nm. The weight contents of the components in the passivation layer are shown in Table 1.

The perovskite cell finally prepared in Example 1-12 has a structure of FTO/SnO₂/TiO₂+2PACz/FAPbI₃/Spiro-OMeTAD/Ag.

### Example 1-13

Except for the difference in the preparation of the passivation layer, the preparation of the perovskite cell is the same as that of Example 1-1.

A mixture of 2wt% TiO₂ nanocolloid-isopropanol solution and 1 mg/mL KCl-isopropanol solution was spin-coated on the electron transport layer at a speed of 5000-6000 rpm, and then heated at 100°C on a thermostatic heating stage for 10min to obtain a passivation layer with a thickness of 15 nm. The weight contents of the components in the passivation layer are shown in Table 1.

The perovskite cell finally prepared in Example 1-13 has a structure of FTO/SnO₂/TiO₂+KCl/FAPbI₃/Spiro-OMeTAD/Ag.

### Example 1-14

Except for the difference in the preparation of the passivation layer, the preparation of the perovskite cell is the same as that of Example 1-1.

A mixture of 0.2 mg/mL 2PACz-isopropanol solution, and 1 mg/mL KCl-isopropanol solution was spin-coated on the electron transport layer at a speed of 5000-6000 rpm, and then heated at 100°C on a thermostatic heating stage for 10min to obtain a passivation layer with a thickness of 4 nm. The weight contents of the components in the passivation layer are shown in Table 1.

The perovskite cell finally prepared in Example 1-14 has a structure of FTO/SnO₂/2PACz+KCl/FAPbI₃/Spiro-OMeTAD/Ag.

### Comparative Example 1-1

Except that the passivation layer is not included, the preparation of the perovskite cell is the same as that of Example 1-1.

The perovskite cell finally prepared in Comparative Example 1-1 has a structure of FTO/SnO₂/FAPbI₃/Spiro-OMeTAD/Ag.

### Comparative Example 1-2

Except for the difference in the preparation of the passivation layer, the preparation of the perovskite cell is the same as that of Example 1-1.

A 2wt% TiO₂ nanocolloid isopropanol solution was spin-coated on the electron transport layer at a speed of 5000-6000 rpm, and then heated at 100°C on a thermostatic heating stage for 10min to obtain a passivation layer with a thickness of 13 nm.

The perovskite cell finally prepared in Comparative Example 1-2 has a structure of FTO/SnO₂/TiO₂/FAPbI₃/Spiro-OMeTAD/Ag.

### Comparative Example 1-3

Except for the difference in the preparation of the passivation layer, the preparation of the perovskite cell is the same as that of Example 1-1.

A 0.2 mg/mL 2PACz solution in isopropanol was spin-coated on the electron transport layer at a speed of 5000-6000 rpm, and then heated at 100°C on a thermostatic heating stage for 10min to obtain a passivation layer with a thickness of 2 nm.

The perovskite cell finally prepared in Comparative Example 1-3 has a structure of FTO/SnO₂/2PACz/FAPbI₃/Spiro-OMeTAD/Ag.

### Comparative Example 1-4

Except for the difference in the preparation of the passivation layer, the preparation of the perovskite cell is the same as that of Example 1-1.

A 1 mg/mL KCl solution in isopropanol was spin-coated on the electron transport layer at a speed of 5000-6000 rpm, and then heated at 100°C on a thermostatic heating stage for 10min to obtain a passivation layer with a thickness of 2 nm.

The perovskite cell finally prepared in Comparative Example 1-4 has a structure of FTO/SnO₂/KCl/FAPbI₃/Spiro-OMeTAD/Ag.

### Testing section

Under 25°C and atmospheric environment, AM1.5G standard light source was used to simulate sunlight, and a four-channel digital source meter (Keithley 2440) was used to measure the volt-ampere characteristic curve of the perovskite cell under the irradiation of the light source to obtain the open-circuit voltage Voc, short-circuit current density Jsc, and fill factor FF of the perovskite cell, from which the energy conversion efficiency Eff of the perovskite cell was calculated.

Eff = Pout/Popt = Voc×Jsc×(Vmpp×Jmpp)/(Voc×Jsc) = Voc×Jsc×FF.

Pout, Popt, Vmpp, and Jmpp are the operating output power, incident light power, maximum power point voltage, and maximum power point current of the perovskite cell, respectively.

Table 1 shows the test results of Examples 1-1 to 1-14 and Comparative Examples 1-1 and 1-4.

**Table 1**

| Serial No. | Passivation layer composition | | | | | | | |
|---|---|---|---|---|---|---|---|---|
| | Organic molecular passivation material | | Metal oxide semiconductor material | | Metal halide | | Passivation layer thickness (nm) | Energy conversion efficiency Eff |
| | Type | Weight content | Type | Weight content | Type | Weight content | | |
| Example 1-1 | 2PACz | 20% | TiO₂ | 50% | KCl | 30% | 17 | 21.9% |
| Example 1-2 | 2PACz | 25% | TiO₂ | 48% | KCl | 27% | 17 | 21.8% |
| Example 1-3 | 2PACz | 30% | TiO₂ | 45% | KCl | 25% | 17 | 21.7% |
| Example 1-4 | 2PACz | 10% | TiO₂ | 55% | KCl | 35% | 17 | 21.6% |
| Example 1-5 | 2PACz | 15% | TiO₂ | 53% | KCl | 32% | 17 | 21.6% |
| Example 1-6 | 2PACz | 40% | TiO₂ | 40% | KCl | 20% | 17 | 21.2% |
| Example 1-7 | 2PACz | 20% | TiO₂ | 50% | KCl | 30% | 5 | 20.7% |
| Example 1-8 | 2PACz | 20% | TiO₂ | 50% | KCl | 30% | 10 | 21.7% |
| Example 1-9 | 2PACz | 20% | TiO₂ | 50% | KCl | 30% | 22 | 21.7% |
| Example 1-10 | 2PACz | 20% | TiO₂ | 50% | KCl | 30% | 30 | 21.2% |
| Example 1-11 | 2PACz | 20% | TiO₂ | 50% | KCl | 30% | 35 | 21.0% |
| Example 1-12 | 2PACz | 20% | TiO₂ | 80% | / | / | 15 | 21.6% |
| Example 1-13 | / | / | TiO₂ | 60% | KCl | 40% | 15 | 21.3% |
| Example 1-14 | 2PACz | 20% | / | / | KCl | 80% | 4 | 21.7% |
| Comparative Example 1-1 | / | / | / | / | / | / | / | 19.5% |
| Comparative Example 1-2 | / | / | TiO₂ | 100% | / | / | 13 | 20.3% |
| Comparative Example 1-3 | 2PACz | 100% | / | / | / | / | 2 | 20.4% |
| Comparative Example 1-4 | / | / | / | / | KCl | 100% | 2 | 20.0% |

### Example 2-1

### Preparation of FTO electrode

A glass substrate sized 2.0 cm×2.0 cm and covered with FTO was taken, and its surface was successively washed twice with acetone and isopropanol, respectively. Then, it was immersed in deionized water for ultrasonic treatment for 10 min, then dried in an air dry oven, and kept in a glove box (N₂ atmosphere).

### Preparation of electron transport layer

A 3wt% SnO₂ nano-colloid aqueous solution was spin-coated on an FTO layer at a speed of 4000-6500 rpm, and then heated at 150°C on a thermostatic heating stage for 15min to obtain an electron transport layer with a thickness of 50 nm.

### Preparation of light absorbing layer

A solution of 1.5mol/L FAPbI₃ in DMF was spin-coated on the electron transport layer at a speed of 3000-4500 rpm, then heated on a thermostatic heating stage at 100°C for 30min, and cooled to room temperature to obtain the light absorbing layer with a thickness of 500 nm.

### Preparation of passivation layer

A mixture of 2wt% CuO nanocolloid-isopropanol solution, 0.2 mg/mL PEAl-isopropanol solution, and 1 mg/mL CuI-isopropanol solution was spin-coated on the light absorbing layer at a speed of 5000-6000 rpm, and then heated at 100°C on a thermostatic heating stage for 10min to obtain a passivation layer with a thickness of 17 nm. The weight contents of the components in the passivation layer are shown in Table 2.

### Preparation of hole transport layer

A solution of Spiro-OMeTAD (73 mg/mL) in chlorobenzene was spin-coated on the passivation layer at a speed of 3000-4000 rpm to obtain a hole transport layer with a thickness of 150 nm.

### Preparation of Ag electrode

The above sample was put into a vacuum coater, and an Ag electrode was evaporated onto the surface of the hole transport layer under the vacuum condition of 5×10⁻⁴ Pa, with an evaporation rate of 0.1 Å/s and a thickness of 80 nm.

The perovskite cell finally prepared in Example 2-1 has a structure of FTO/SnO₂/FAPbI₃/CuO+PEAI+CuI/Spiro-OMeTAD/Ag.

### Example 2-2

Except for the difference in the preparation of the passivation layer, the preparation of the perovskite cell is the same as that of Example 2-1.

A mixture of 2wt% CuO nanocolloid-isopropanol solution and 0.2 mg/mL PEAI-isopropanol solution was spin-coated on the light absorbing layer at a speed of 5000-6000 rpm, and then heated at 150°C on a thermostatic heating stage for 30min to obtain a passivation layer with a thickness of 15 nm. The weight contents of the components in the passivation layer are shown in Table 2.

The perovskite cell finally prepared in Example 2-2 has a structure of FTO/SnO₂/FAPbI₃/CuO+PEAI/Spiro-OMeTAD/Ag.

### Example 2-3

Except for the difference in the preparation of the passivation layer, the preparation of the perovskite cell is the same as that of Example 2-1.

A mixture of 2wt% CuO nanocolloid-isopropanol solution and 1 mg/mL CuI-isopropanol solution was spin-coated on the light absorbing layer at a speed of 5000-6000 rpm, and then heated at 100°C on a thermostatic heating stage for 10min to obtain a passivation layer with a thickness of 15 nm. The weight contents of the components in the passivation layer are shown in Table 2.

The perovskite cell finally prepared in Example 2-3 has a structure of FTO/SnO₂/FAPbI₃/CuO+CuI/Spiro-OMeTAD/Ag.

### Example 2-4

Except for the difference in the preparation of the passivation layer, the preparation of the perovskite cell is the same as that of Example 2-1.

A mixture of 0.2 mg/mL PEAI-isopropanol solution and 1 mg/mL CuI-isopropanol solution was spin-coated on the light absorbing layer at a speed of 5000-6000 rpm, and then heated at 100°C on a thermostatic heating stage for 10min to obtain a passivation layer with a thickness of 4 nm. The weight contents of the components in the passivation layer are shown in Table 2.

The perovskite cell finally prepared in Example 2-4 has a structure of FTO/SnO₂/FAPbI₃/PEAI+CuI/Spiro-OMeTAD/Ag.

### Comparative Example 2-1

Except for the difference in the preparation of the passivation layer, the preparation of the perovskite cell is the same as that of Example 2-1.

A 2wt% CuO nanocolloid isopropanol solution was spin-coated on the light absorbing layer at a speed of 5000-6000 rpm, and then heated at 100°C on a thermostatic heating stage for 10min to obtain a passivation layer with a thickness of 13 nm.

The perovskite cell finally prepared in Comparative Example 2-1 has a structure of FTO/SnO₂/FAPbI₃/CuO/Spiro-OMeTAD/Ag.

### Comparative Example 2-2

Except for the difference in the preparation of the passivation layer, the preparation of the perovskite cell is the same as that of Example 2-1.

A 0.2 mg/mL PEAI solution in isopropanol was spin-coated on the light absorbing layer at a speed of 5000-6000 rpm, and then heated at 100°C on a thermostatic heating stage for 10min to obtain a passivation layer with a thickness of 2 nm.

The perovskite cell finally prepared in Comparative Example 2-2 has a structure of FTO/SnO₂/FAPbI₃/PEAI/Spiro-OMeTAD/Ag.

### Comparative Example 2-3

Except for the difference in the preparation of the passivation layer, the preparation of the perovskite cell is the same as that of Example 2-1.

A 1 mg/mL CuI solution in isopropanol was spin-coated on the light absorbing layer at a speed of 5000-6000 rpm, and then heated at 100°C on a thermostatic heating stage for 10min to obtain a passivation layer with a thickness of 2nm.

The perovskite cell finally prepared in Comparative Example 2-3 has a structure of FTO/SnO₂/FAPbI₃/CuI/Spiro-OMeTAD/Ag.

Table 2 shows the test results of Examples 2-1 to 2-4 and Comparative Examples 2-1 and 2-3. The testing method of the perovskite cell is the same as that of Examples 1-1 to 1-14.

**Table 2**

| Serial No. | Passivation layer composition | | | | | | Passivation layer thickness (nm) | Energy conversion efficiency Eff |
|---|---|---|---|---|---|---|---|---|
| | Organic molecular passivation material | | Metal oxide semiconductor material | | Metal halide | | | |
| | Type | Weight content | Type | Weight content | Type | Weight content | | |
| Example 2-1 | PEAI | 20% | CuO | 50% | CuI | 30% | 17 | 21.7% |
| Example 2-2 | PEAI | 20% | CuO | 80% | / | / | 15 | 21.2% |
| Example 2-3 | / | / | CuO | 60% | CuI | 40% | 15 | 21.0% |
| Example 2-4 | PEAI | 20% | / | / | CuI | 80% | 4 | 21.3% |
| Comparative Example 2-1 | / | / | CuO | 100% | / | / | 13 | 20.0% |
| Comparative Example 2-2 | PEAI | 100% | / | / | / | / | 2 | 20.2% |
| Comparative Example 2-3 | / | / | / | / | CuI | 100% | 2 | 20.1% |

It can be seen from the test results in Table 1 and Table 2 that Comparative examples 1-2 to 1-4 and Comparative Examples 2-1 to 2-3 respectively use an organic molecular passivation material, a metal oxide semiconductor material or a metal halide as the passivation layer, and they do not have obvious effects in improving the energy conversion efficiency of the perovskite cell compared with Comparative Example 1-1.

Comparative Example 1-2 and Comparative Example 2-1 use a metal oxide semiconductor material as the passivation layer. Metal oxide semiconductor materials have high structural stability, but their effect of promoting the crystallization quality of perovskite is limited. In particular, the passivation layer of Comparative Example 2-1 is formed after the light absorbing layer, which will further reduce the effect in promoting the crystallization quality of perovskite, resulting in a lack of obvious effect in improving the energy conversion efficiency of the perovskite cell.

Comparative Example 1-3 and Comparative Example 2-2 use an organic molecular passivation material as the passivation layer. The structural stability of the organic molecular passivation material is poor, which results in a lack of significant effect in improving the energy conversion efficiency of the perovskite cell.

Comparative Example 1-4 and Comparative Example 2-3 use a metal halide as the passivation layer. The carrier transport capacity of KCl is limited, which results in a lack of obvious improvement in the energy conversion efficiency of the perovskite cell. The interface passivation effect of CuI is limited, which results in a lack of obvious improvement in the energy conversion efficiency of the perovskite cell.

It can be seen from the test results in Tables 1 and 2 that by providing a passivation layer between the hole transport layer and the light absorbing layer, and/or between the electron transport layer and the light absorbing layer, and making the passivation layer comprise at least two of an organic molecule passivation material, a metal oxide semiconductor material, and a metal halide, the passivation layer can simultaneously have the effects of energy level matching, interface passivation, and optimization of the crystallization quality of the perovskite material, thereby further improving the energy conversion efficiency of the perovskite cell.

It can also be seen from the test results in Tables 1 and 2 that when the passivation layer comprises an organic molecular passivation material and a metal oxide semiconductor material and/or a metal halide, the energy conversion efficiency of the perovskite cell can be further improved. This is because organic molecular passivation materials can act as both interface adhesives and defect passivators, so that the interface contact between the light absorbing layer and the charge transport layer can be enhanced through the organic molecular passivation material. The defect density in the bulk and interface of the perovskite material can also be reduced through the coordination effect of the organic molecular passivation material, thereby improving the film formation quality of the light absorbing layer. The organic molecular passivation material can also be embedded in the bulk of the perovskite material to play an anchoring role to reduce the precipitation of halides from the perovskite material. Therefore, when organic molecular passivation materials are used in combination with metal oxide semiconductor materials and/or metal halides, they can further reduce non-radiative recombination at defects and further improve the energy conversion efficiency of perovskite cells.

It can also be seen from the test results in Tables 1 and 2 that when a passivation layer is provided between the charge transport layer close to the light incident side and the light absorbing layer, the energy conversion efficiency of the perovskite cell can be better improved. This is because the passivation layer can better promote the crystallization of perovskite materials.

While the above description merely provides specific embodiments of the present application, the scope of protection of the present application is not limited to the specific embodiments. Any person skilled in the art may easily conceive of various equivalent modifications or substitutions without departing from the technical scope disclosed in the present application. All these modifications or substitutions should be encompassed within the scope of protection of the present application. Therefore, the scope of the present application shall be determined with reference to the scope of the claims.

## Claims

1. A perovskite cell, comprising:
a first electrode;
a second electrode;
a light absorbing layer located between the first electrode and the second electrode;
a hole transport layer located between the first electrode and the light absorbing layer; and
an electron transport layer located between the second electrode and the light absorbing layer, wherein,
the perovskite cell further comprises a passivation layer, the passivation layer is located between the hole transport layer and the light absorbing layer, and/or the passivation layer is located between the electron transport layer and the light absorbing layer; and
the passivation layer comprises at least two of an organic molecular passivation material, a metal oxide semiconductor material and a metal halide.

2. The perovskite cell according to claim 1, wherein,
the passivation layer comprises an organic molecular passivation material and a metal oxide semiconductor material and/or a metal halide,
optionally, based on the total weight of the passivation layer, the content of the organic molecular passivation material is 10-30wt%, and more optionally 15-25wt%.

3. The perovskite cell according to claim 1 or 2, wherein the passivation layer comprises an organic molecule passivation material, a metal oxide semiconductor material and a metal halide,
optionally, based on the total weight of the passivation layer, the content of the organic molecular passivation material is 10-30wt%, and more optionally 15-25wt%;
optionally, based on the total weight of the passivation layer, the content of the metal oxide semiconductor material is 40-60wt%, and more optionally 45-55wt%;
optionally, based on the total weight of the passivation layer, the content of the metal halide is 20-40wt%, and more optionally 25-35wt%.

4. The perovskite cell according to claim 1 or 2, wherein the passivation layer comprises an organic molecule passivation material and a metal oxide semiconductor material,
optionally, based on the total weight of the passivation layer, the content of the organic molecular passivation material is 10-30wt%, and more optionally 15-25wt%;
optionally, based on the total weight of the passivation layer, the content of the metal oxide semiconductor material is 70-90wt%, and more optionally 75-85wt%.

5. The perovskite cell according to claim 1 or 2, wherein the passivation layer comprises an organic molecule passivation material and a metal halide,
optionally, based on the total weight of the passivation layer, the content of the organic molecular passivation material is 10-30wt%, and more optionally 15-25wt%;
optionally, based on the total weight of the passivation layer, the content of the metal halide is 70-90wt%, and more optionally 75-85wt%.

6. The perovskite cell according to any one of claims 1 to 5, wherein the thickness of the passivation layer is less than or equal to 30nm, and optionally 1-22nm.

7. The perovskite cell according to any one of claims 1 to 6, wherein the organic molecule passivation material includes one or more of alkylamines and halogen salts thereof, aromatic amines and halogen salts thereof, aromatic heterocyclic compounds, polymers, and their respective derivatives,
optionally, the aromatic heterocyclic compound includes one or more of nitrogen-containing aromatic heterocyclic rings and their derivatives, and more optionally includes one or more of carbazole, pyridine, piperidine, and their respective derivatives;
optionally, the polymer includes one or more of polyaniline, polypyridine, polypiperidine, and their respective derivatives.

8. The perovskite cell according to claim 7, wherein,
the organic molecular passivation material includes one or more of N,N-Diethylaniline, 2-Phenylethylamine Hydroiodide, Dopamine, 9,9-Bis(4-aminophenyl)fluorene, [2-(9H-carbazol-9-yl)ethyl]phosphonic acid, [2-(3,6-dimethoxy-9H-carbazol-9-yl)ethyl]phosphonic acid, [4-(3,6-dimethyl-9H-carbazol-9-yl)butyl]phosphoric acid, 4-pyridinecarboxylic acid, polyaniline, polypyridine, polypiperidine, and their respective derivatives,
optionally, the organic molecular passivation material includes one or more of [2-(9H-carbazol-9-yl)ethyl]phosphonic acid, 2-Phenylethylamine Hydroiodide, and their respective derivatives.

9. The perovskite cell according to any one of claims 1 to 8, wherein the metal oxide semiconductor material includes one or more of an intrinsic metal oxide semiconductor material, an N-type metal oxide semiconductor material, and a P-type metal oxide semiconductor material, and optionally includes one or more of SnO₂, TiO₂, ZnO, NiOₓ, CeOₓ, MoO₃, NiMgLiO, CuGaO₂, CuGrO₂, CuO, Cu₂O, and their respective doping materials, where 1≤x≤2.

10. The perovskite cell according to claim 9, wherein,
when the passivation layer is located between the hole transport layer and the light absorbing layer, the metal oxide semiconductor material includes one or more of an intrinsic metal oxide semiconductor material and a P-type metal oxide semiconductor material, and optionally includes one or more of NiOₓ, CeOₓ, MoO₃, NiMgLiO, CuGaO₂, CuGrO₂, CuO, Cu₂O, and their respective doping materials, where 1≤x≤2; and
when the passivation layer is located between the electron transport layer and the light absorbing layer, the metal oxide semiconductor material includes one or more of an intrinsic metal oxide semiconductor material and an N-type metal oxide semiconductor material, and optionally includes one or more of SnO₂, TiO₂, ZnO, and their respective doping materials.

11. The perovskite cell according to any one of claims 1 to 10, wherein the particle size of the metal oxide semiconductor material is 100nm or less, optionally 50nm or less, and more optionally 5-10nm.

12. The perovskite cell according to any one of claims 1 to 11, wherein,
the metal element in the metal halide includes one or more of alkali metal elements, alkaline earth metal elements, and transition metal elements, and optionally includes one or more of K, Cs, Pb, and Cu; and/or,
the halogen element in the metal halide includes one or more of F, Cl, Br, and I.

13. The perovskite cell according to claim 12, wherein the metal halide includes one or more of CsF, KCl, PbBr, CuI, and CuI₂, and optionally includes one or more of KCl and CuI.

14. The perovskite cell according to any one of claims 1 to 13, wherein,
the electron transport material in the electron transport layer includes one or more of imide compounds, quinone compounds, fullerene and its derivatives, a second metal oxide, silicon oxide, strontium titanate, calcium titanate, lithium fluoride, and calcium fluoride, and optionally, the metal element in the second metal oxide includes one or more of Mg, Cd, Zn, In, Pb, W, Sb, Bi, Hg, Ti, Ag, Mn, Fe, V, Sn, Zr, Sr, Ga and Cr; and/or,
the hole transport material in the hole transport layer includes one or more of 2,2',7,7'-tetrakis(N,N-p-methoxyanilino)-9,9'-spirobifluorene, methoxytriphenylamine-fluoroformamidine, poly[bis(4-phenyl)(2,4,6-trimethylphenyl)amine], poly(3,4-ethylenedioxythiophene):polystyrene sulfonic acid, poly(3-hexylthiophene), triphenylamine with triptycene as the core, 3,4-ethylenedioxythiophene-methoxytriphenylamine, N-(4-aniline)carbazol-spirobifluorene, polythiophene, phosphate-based unimolecules, carbazole-based unimolecules, sulfonic acid-based unimolecules, triphenylamine-based unimolecules, aromatic unimolecules, a third metal oxide and cuprous thiocyanate, and the metal element in the third metal oxide includes one or more of Ni, Mo and Cu; and/or,
the perovskite material in the light absorbing layer includes one or more of an inorganic halide perovskite material, an organic halide perovskite material, and an organic-inorganic hybrid halide perovskite material.

15. The perovskite cell according to any one of claims 1 to 14, wherein the electrode materials of the first electrode and the second electrode each independently include organic conductive materials, inorganic conductive materials or organic-inorganic hybrid conductive materials, and optionally include one or more of poly(3,4-ethylenedioxythiophene), polythiophene, polyacetylene, fluorine-doped tin oxide, indium tin oxide, antimony-doped tin oxide, aluminum-doped zinc oxide, boron-doped zinc oxide, indium-doped zinc oxide, gold, silver, aluminum, copper, carbon and their derivatives.

16. A photovoltaic module, comprising the perovskite cell according to any one of claims 1 to 15.
